# EUROPEAN PATENT APPLICATION

(11) **EP 1 657 845 A2**
(43) Date of publication of application: **17.05.2006**
(21) Application number: 05024290.8
(22) Date of filing: 08.11.2005
(51) Int. Cl.: H04L 1/18

(54) **Dynamic retransmission mode selector**

(30) Priority: 10.11.2004 US 626845 P
(71) Applicant: Nortel Networks Limited, St.Laurent, Quebec H4S 2A9 (CA)
(72) Inventor: Taffin, Arnauld, 91440 Bures sur Yvette (FR); Jard, Alexandre, 92150 Suresnes (FR)
(74) Representative: Ameline, Jean-Paul B.C.

(57) **Abstract**

A method of selecting a retransmission mode, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme prior to transmission over the interface, is provided. The number of bits to be encoded and the number of bits to be sent over the interface are compared, and a type of retransmission mode for the retransmission of the first transmitted data is determined.

## Description

### FIELD OF THE INVENTION

The present invention relates to methods and apparatus to provide techniques for transmitting data in acknowledged mode with re-transmission from a sending unit to a receiving unit. It is in particular directed to radiocommunication systems such as wireless telecommunication systems including cellular wireless communication systems.

### BACKGROUND OF THE INVENTION

In third generation radio communication networks of the UMTS type ("Universal Mobile Telecommunication System") HSDPA ("High Speed Downlink Packet Access") functionality is available. An overall description of the HSDPA functionality can be found in the technical specification TS 25.308, Release 6, version 6.2.0, published in September 2004 by the 3GPP.

In the UMTS system, a "High Speed Uplink Packet Access" (HSUPA) feature is currently being specified by the 3GPP (3^{rd} Generation Partnership Project) - also named "FDD enhanced uplink" in 3GPP terminology, or "E-DCH" according to the transport channel's name.

HSDPA allows the transmission, by a base station, of data at high throughput in respect of a set of radio terminals situated in the zone of coverage of a base station. It relies on a time-sharing and code-sharing high-throughput downlink transport channel: the HS-DSCH ("High Speed - Downlink Shared Channel"). UMTS allows a TDD (Time Division Duplex) and an FDD ("Frequency Division Duplex") mode. In the FDD mode, the characteristics of this channel are in particular: (i) a transmission time interval (TTI) of 2 milliseconds corresponding to 3 time slots of 666 µs; (ii) hybrid data retransmission request processes of HARQ type ("Hybrid Automatic Repeat reQuest"); and (iii) an adaptive coding and modulation mechanism.

HSUPA is a new feature currently being specified by the 3GPP, in order to provide high speed uplink transmission, i.e. from a UE to the access network.

This service is based on the so-called "E-DCH", a new type of transport channel which also supports hybrid data retransmission request processes of HARQ type, an adaptive coding and modulation mechanism, and base station scheduling of the uplink data transmissions.

There are 3 main types, or modes, for an HARQ protocol: HARQ in mode 1 is a pure repetition mode, i.e. the same block is retransmitted. Usually corrupted blocks are discarded by the receiver. A variant consists in memorizing erroneous blocks and combining all retransmissions of a same block together. When optimum combining at the bit level is performed, this has been called Chase Combining (CC) in reference to the technical paper entitled: "Code Combining - A Maximum-Likelihood Decoding Approach for Combining an Arbitrary Number of Noisy Packets" published by David Chase in 1985 (IEEE Trans. Comm. Tech., vol COM-33, No. 5, May 1985).

HARQ in mode 2 corresponds to Incremental Redundancy (IR). The retransmission of a non self-decodable version of the original block is allowed, i.e. a non self-decodable version cannot be decoded alone. Prior to decoding it, it must be combined with a previously received self-decodable version. In general, optimum combining is performed for bits already transmitted. For retransmissions, priority is given to parity bits, which have been punctured in previous transmission attempts, i.e. systematic bits may be fully punctured if necessary. It is also sometimes called Full IR (FIR) within 3GPP.

HARQ in mode 3 belongs to the IR family. The difference between both IR types is that an additional constraint is imposed in HARQ of type 3 redundancy versions. These redundancy versions must be self-decodable, i.e. in the case of turbo encoded data blocks all systematic bits must be transmitted for each retransmission. Optimum combining is performed for bits already transmitted. This is also sometimes called Partial IR (PIR) within 3GPP.

For HSDPA, at the access network level, a specific sublayer of the medium access control protocol, MAC-hs ("Medium Access Control - high speed"), is localized in the base station. This layer receives data originating from the so-called MAC-d sublayer localized, for its part, in the radio network controller RNC on which the base station depends. Thus, matters are arranged such as to offer an optimum throughput on the HS-DSCH channel. For the same reason, the HS-PDSCH uses a relatively low spreading factor, equal to 16. In a given cell and for a given scrambling code, up to 15 HS-PDSCH channels may be established using orthogonal "channelization" codes. Details regarding medium access control may be found in the technical specification TS 25.321, Release 6, version 6.2.0, published in June 2004 by the 3GPP.

For an HS-DSCH channel, it is necessary to provide one or more specific shared physical control channels called HS-SCCH ("High Speed - Shared Control CHannel"). The signaling information carried by the HS-SCCHs identify the destination terminals of the blocks transmitted on the HS-PDSCHs, and provide them with a certain number of indications useful for the reception of these blocks:
- a transport format and resource indicator (TFRI), giving the information concerning the format of the dynamic part of the HS-DSCH channel, in particular for the modulation scheme employed, and the physical resources allocated ("channelization" codes);
- the information related to the HARQ protocol, in particular the redundancy version, an HARQ process identifier, and an indicator of new data blocks.

Feedback information is moreover returned by the terminal, in particular for the acknowledgements of the HARQ protocol, for the measurements useful for link adaptation. This information is transmitted by a dedicated uplink resource, on a channel dubbed HS-DPCCH ("High Speed - Dedicated Physical Control Channel"). A link adaptation makes it possible to modify the shaping format of the data to be transmitted as a function of the quality of the radio link. For this purpose, a shaping request based on an estimate of the signal-to-interference ratio of the downlink, called CQI ("Channel Quality Indicator"), is periodically returned to the base station by the terminal. The parameter CQI is coded on 30 levels, the gap between two levels corresponding to a gap of 1 dB in the signal-to-interference ratio.

Moreover, each terminal can provide the base station under whose radio coverage it finds itself, by way of the RNC, with information concerning its reception capabilities. It thus indicates to the base station in particular:
- whether it supports the two modulations provided for in the system; namely QPSK ("Quadrature Phase Shift Keying") modulation and 16-QAM ("16-Quadrature Amplitude Modulation") modulation, or else just one of them;
- if its memory allows it to receive data at every TTI, or else every n TTI only, with n an integer;
- if its memory allows it to implement all the possible modes of the HARQ protocol (repetition mode, total or partial Incremental Redundancy mode), or else only some of them.

On setting up the HS-DSCH and HS-SCCHs, the radio network controller which supervises the base station (CRNC, "Controlling RNC") allocates it the corresponding code resources, per cell. By way of example, provision may be made to reserve a list of L = 16 codes with spreading factor 128 for the HS-SCCH channels.

At each TTI, these resources are distributed among various users for which data are to be transmitted. To do this, an allocation of resources is performed by the MAC-hs sublayer of the base station considered.

For HSUPA, at the MAC level, a new MAC termination point, the MAC-e, has also been introduced in the UTRAN architecture, and more specifically at the base station level. This architecture is described in the 3GPP TS 25.309 draft specification "Enhanced uplink UTRA FDD; Stage 2", version 0.2.0, published in July 2004 by the 3GPP.

Current known implementations of the HARQ protocol in the HSDPA feature provide a configuration of the HARQ protocol at the system configuration level. This lacks flexibility and does not optimize the gain of the HARQ protocol scheme.

### SUMMARY OF THE INVENTION

An object of the present invention is to provide an enhanced apparatus and a process to limit the abovementioned drawbacks.

The present invention provides an enhanced apparatus and process by which a retransmission mode is dynamically selected among a plurality of available retransmission modes in accordance with a selection parameter.

An advantage of the present invention is that rate matching parameters are dynamically configured so as to optimize retransmission gain.

According to one broad aspect, the invention provides a method of selecting a retransmission mode, for transmission of data which have been first transmitted in acknowledged mode between a transmitter unit and a receiver unit over an interface, and for which no positive acknowledgement of said first transmission has been received at the transmitter unit, the data being processed according to an error detection encoding scheme or an error correcting encoding scheme prior to transmission over the interface, the method comprising:
first comparing the number of bits to be encoded (N_{SYS}) and the number of bits to be sent over the interface (N_{DATA}), and
determining, responsive to said first comparison, a type of retransmission mode for the retransmission of the first transmitted data.

In some embodiments, the method further comprises a second comparison of a number of bits representative of an available memory size at the receiver unit (N_{IR}) and the number of bits to be sent over the air interface (N_{DATA}), and determining, responsive to said first and second comparisons, a type of retransmission mode for the retransmission of the first transmitted data.

In some embodiments, determining of the retransmissison type can comprise determining whether the retransmission of data may be done according to an incremental redundancy scheme.

In some embodiments, the second comparison comprises a comparison of a number of bits representing a maximum memory size at the receiver unit available for a retransmission process (N_{IR}), with the number of bits to be sent over the interface (N_{DATA}).

In some embodiments, the first comparison of the number of bits to be encoded (N_{SYS}) and the number of bits to be sent over the interface (N_{DATA}) comprises:
comparing an overall coding rate (N_{SYS}/N_{DATA}) to an error correcting encoding rate.

In some embodiments, determining a type of retransmission mode comprises:
excluding an incremental redundancy retransmission scheme if an overall coding rate (N_{SYS}/N_{DATA}) is smaller than an error correcting encoding rate.

In some embodiments, determining a type of retransmission mode comprises:
excluding an incremental redundancy retransmissionscheme if an overall coding rate (N_{SYS}/N_{DATA}) is greater than an error correcting encoding rate and the number of bits representing a maximum memory size at the receiver unit available for a retransmission process (N_{IR}) is smaller than the number of bits to be sent over the interface (N_{DATA}).

In some embodiments, determining a type of retransmission mode comprises:
selecting an incremental redundancy retransmission scheme if an overall coding rate (N_{SYS}/N_{DATA}) is greater than an error correcting encoding rate and the number of bits representing a maximum memory size at the receiver unit available for a retransmission process (N_{IR}) is greater than the number of bits to be sent over the interface (N_{DATA}).

In some embodiments, the error correcting scheme is turbo coding, and the error correcting encoding rate equals 1/3.

Another broad aspect provides a method for transmitting data over an interface, the data being processed according to an error correcting encoding scheme and a rate matching scheme prior to transmission over the interface, further comprising the steps of calculating a number (N_{PUNCT2}) of bits to be punctured in order to match the number of bits to be sent over the interface (N_{DATA}), a third comparison of the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}) and selecting, responsive to said third comparison, an incremental redundancy scheme for the retransmission of the first transmitted data.

Another broad aspect provides a method of selecting an incremental redundancy retransmission scheme, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme or an error detection encoding scheme and a rate matching scheme prior to transmission over the interface, the method comprising the steps of determining whether the retransmission of data may be done according to an incremental redundancy retransmission scheme, calculating a number (N_{PUNCT2}) of bits to be punctured in order to match the number of bits to be sent over the interface (N_{DATA}), comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}) and selecting, responsive to said comparison, an incremental redundancy scheme for the retransmission of the first transmitted data.

In some embodiments, the selecting of an incremental redundancy scheme for the retransmission of data comprises: selecting a Full Incremental Redundancy mode or a Partial Incremental Redundancy Mode.

In some embodiments, the selecting of an incremental redundancy scheme for the retransmission of data, comprises selecting a predetermined incremental redundancy scheme for the retransmission of data if the number of bits, exclusive of the number of bits to be encoded (N_{SYS}), to be sent over the interface (N_{DATA} - N_{SYS}) is smaller than said number (N_{PUNCT2}) of bits to be punctured in order to match the number of bits to be sent over the interface (N_{DATA}).

In some embodiments, said selected predetermined incremental redundancy scheme is Full Incremental Redundancy.

In some embodiments, the selecting of an incremental redundancy scheme for the retransmission of data, comprises selecting a predetermined incremental redundancy scheme for the retransmission of data if the number of bits, exclusive of the number of bits to be encoded (N_{SYS}), to be sent over the interface (N_{DATA} - N_{SYS}) is greater than said number (N_{PUNCT2}) of bits to be punctured in order to match the number of bits to be sent over the interface (N_{DATA}).

In some embodiments, selected predetermined incremental redundancy scheme is Partial Incremental Redundancy.

Another broad aspect provides a retransmission mode selector adapted to implement the above-mentioned methods. Another broad aspect provides an incremental redundancy retransmission scheme selector, adapted to implement some of the above-mentioned methods.

A dynamic retransmission mode selector in accordance with the present invention is adapted for selecting a retransmission mode, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme prior to transmission over the interface. The selector includes means for first comparing the number of bits to be encoded (N_{SYS}) and the number of bits to be sent over the interface (N_{DATA}); and means for determining, responsive to said first comparison, a type of retransmission mode for the retransmission of the first transmitted data. The selector may also include means for a second comparing of a number of bits representative of an available memory size at the receiver unit (N_{IR}) and the number of bits to be sent over the air interface (N_{DATA}); and means for determining, responsive to said first and second comparisons, a type of retransmission mode for the retransmission of the first transmitted data. In the selector the means for determining a type of retransmission mode may comprise means determining whether the retransmission of data may be done according to an incremental redundancy scheme. In the selector the means for the second comparing may comprise means for a comparison of a number of bits representing a maximum memory size at the receiver unit available for a retransmission process (N_{IR}), with the number of bits to be sent over the interface (N_{DATA}). In the selector the means for first comparing of the number of bits to be encoded (N_{SYS}) and the number of bits to be sent over the interface (N_{DATA}) may comprise means for comparing the overall coding rate (N_{SYS}/N_{DATA}) to the error correcting encoding rate (1/n). In the selector the means for determining of a type of retransmission mode may comprise means for excluding an incremental redundancy retransmission scheme if the overall coding rate (N_{SYS}/N_{DATA}) is smaller than the error correcting encoding rate (1/n).
In the selector, the means for determining of a type of retransmission mode may comprise means for excluding an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is smaller than the number of bits to be sent over the interface (N_{DATA}). In the selector the means for determining a type of retransmission mode may comprise means for selecting an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is greater than the number of bits to be sent over the interface (N_{DATA}).
In a further aspect of the present invention retransmission mode selector is provided when the transmitted data is processed according to an error correcting encoding scheme and a rate matching scheme prior to transmission over the interface, the selector including means for calculating a number (N_{PUNCT2}) of bits to be punctured in order to match the number of bits to be sent over the interface (N_{DATA}); and means for third comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}); and means for selecting, responsive to said third comparison, an incremental redundancy scheme for the retransmission of the first transmitted data.

The present invention also provides a dynamic retransmission selector for selecting an incremental redundancy retransmission scheme, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme and a rate matching scheme prior to transmission over the interface. The selector has means for determining whether the retransmission of data may be done according to an incremental redundancy retransmission scheme; means for calculating a number (N_{PUNCT2}) of bits to be punctured in order to match the number of bits to be sent over the interface (N_{DATA}); means for comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}); and means for selecting, responsive to said comparison, an incremental redundancy scheme for the retransmission of the first transmitted data. The means for selecting of an incremental redundancy scheme for the retransmission of data may comprise means for selecting the Full Incremental Redundancy mode or the Partial Incremental Redundancy Mode. The means for selecting of an incremental redundancy scheme for the retransmission of data, may comprise means for selecting a predetermined incremental redundancy scheme for the retransmission of data if the number of bits, exclusive of the number of bits to be encoded (N_{SYS}), to be sent over the interface (N_{DATA} - N_{SYS}) is smaller than said number (N_{PUNCT2}) of bits to be punctured in order to match the number of bits to be sent over the interface (N_{DATA}). The means for selecting an incremental redundancy scheme for the retransmission of data, may comprise means for selecting a predetermined incremental redundancy scheme for the retransmission of data if the number of bits, exclusive of the number of bits to be encoded (N_{SYS}), to be sent over the interface (N_{DATA} - N_{SYS}) is greater than said number (N_{PUNCT2}) of bits to be punctured in order to match the number of bits to be sent over the interface (N_{DATA}).

Another broad aspect provides a computer readable medium having processor executable instructions thereon for implementation by a processor, the instructions executing any of the above-mentioned methods.

Another broad aspect provides a signal processing apparatus, e.g. for use in a transmitter unit adapted to transmit data to a receiver unit in acknowledged mode over an interface, the signal processing apparatus comprising, for the transmission of data which have been first transmitted between said transmitter unit and a receiver unit over an interface, and for which no positive acknowledgement of said first transmission has been received at the transmitter unit, the data being processed according to an error correcting encoding scheme prior to transmission over the interface, first comparator means, for first comparing of the number of bits to be encoded (N_{SYS}) and the number of bits to be sent over the interface and first control means, for determining, responsive to said first comparison, a type of retransmission mode for the retransmission of the first transmitted data.

In some embodiments, the signal processing apparatus further comprises second comparator means for second comparing of a number of bits representative of an available memory size at the receiver unit (N_{IR}) and the number of bits to be sent over the air interface (N_{DATA}) and second control means, for determining, responsive to said first and second comparisons, a type of retransmission mode for the retransmission of the first transmitted data.

In some embodiments, said first comparator means of the signal processing apparatus are adapted to compare the overall coding rate (N_{SYS}/N_{DATA}) with the error correcting encoding rate.

Another broad aspect provides a signal processing apparatus, e.g. in a transmitter unit adapted to transmit data to a receiver unit in acknowledged mode over an interface, the signal processing apparatus comprising, for the transmission of data which have been first transmitted between said transmitter unit and a receiver unit over an interface, and for which no positive acknowledgement of said first transmission has been received at the transmitter unit, the data being processed according to an error correcting encoding scheme and a rate matching scheme prior to transmission over the interface, means for determining whether the retransmission of data may be done according to an incremental redundancy retransmission scheme, means for calculating a number (N_{PUNCT2}) of bits to be punctured in order to match the number of bits to be sent over the interface (N_{DATA}), means for comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}), means for selecting, responsive to said comparison, an incremental redundancy scheme for the retransmission of the first transmitted data.

Another broad aspect provides a base station comprising a signal processing apparatus as mentioned above.

Another broad aspect provides a mobile terminal comprising a signal processing apparatus as mentioned above.

### BRIEF DESCRIPTION OF THE DRAWINGS

Figure 1 is a diagram representing the HSDPA double stage rate matching process as specified by the 3GPP;
Figure 2 is a curve illustrating the gain of Incremental Redundancy when compared to Chase Combining for terminals of categories 1 to 6;
Figure 3 is a curve illustrating the gain of Incremental Redundancy when compared to Chase Combining for terminals of categories 7 and 8;
Figure 4 is a curve illustrating the gain of Incremental Redundancy when compared to Chase Combining for terminals of category 9;
Figure 5 is a curve illustrating the gain of Incremental Redundancy when compared to Chase Combining for terminals of category 10;
Figure 6 is a curve illustrating the gain of Incremental Redundancy when compared to Chase Combining for terminals of categories 11 and 12;
Figure 7 is a block diagram of a method provided by a preferred embodiment of the invention in the case of a HSDPA transmission;
Figure 8 is a block diagram of a method provided by a preferred embodiment of the invention in the case of a HSUPA transmission;
Figure 9 is a curve illustrating the coding rate gain of Incremental Redundancy versus Chase combining between the first transmission tentative and the first retransmission, for terminals of category 9;
Figure 10 is a curve illustrating the coding rate gain of Incremental Redundancy versus Chase combining between the first transmission tentative and the first retransmission, for terminals of categories 7 and 8;
Figure 11 is a curve illustrating the coding rate gain of Incremental Redundancy versus Chase combining between the first transmission tentative and the first retransmission, for terminals of category 10;
Figure 12 is a curve illustrating the coding rate gain of Incremental Redundancy versus Chase combining between the first transmission tentative and the first retransmission, for terminals of categories 11 and 12.
Figure 13 is schematic diagram of an implementation of an embodiment of the present invention.

### DETAILED DESCRIPTION OF THE PREFERRED EMBODIMENTS

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

For purposes of example only, the present invention will be described more particularly in its application, non-limiting, to third generation radio communication networks of the UMTS type ("Universal Mobile Telecommunication System"). It will be described herein below within the context of the HSDPA ("High Speed Downlink Packet Access") functionality, available in the UMTS ("Universal Mobile Telecommunication System") radiocommunication system, without thereby restricting the generality of its subject matter. An overall description of the HSDPA functionality can be found in the technical specification TS 25.308, Release 6, version 6.2.0, published in September 2004 by the 3GPP.

In the UMTS system, the invention also finds application for example, within the framework of the "High Speed Uplink Packet Access" (HSUPA) feature currently being specified by the 3GPP (3^{rd} Generation Partnership Project) - also named "FDD enhanced uplink" in 3GPP terminology, or "E-DCH" according to the transport channel's name.

### HSDPA Incremental Redundancy and Rate Matching algorithm in 3GPP Release 5

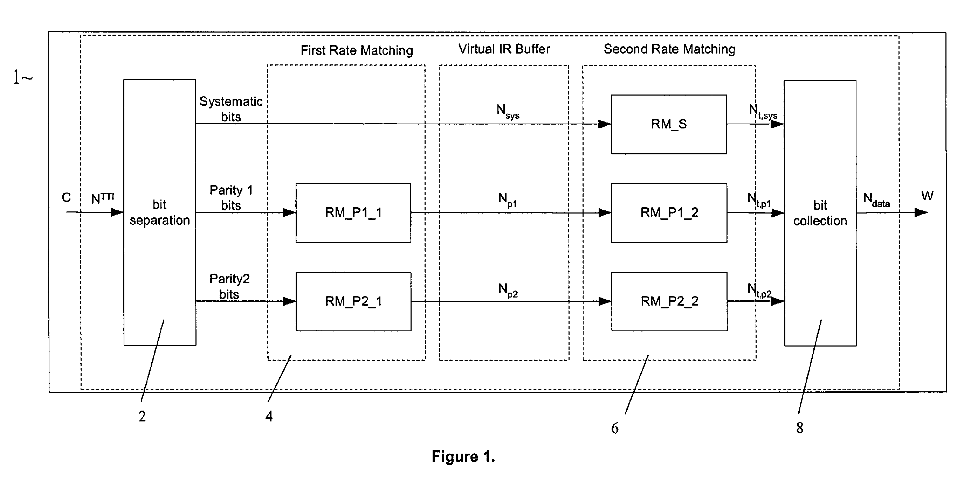

The 3GPP release 5 rate matching algorithm is described in the specification TS 25.212, "Multiplexing and Channel Coding (FDD)", Release 5, version 5.9.0, published in June 2004 by the 3GPP. The rate matching is described in section 4.2.7 of this specification, which is incorporated herein by reference. This algorithm features a double stage rate matching process as illustrated in figure 1 (first rate matching 4 and second rate matching 6).

The rate matching function 1 performs either puncturing or repetition, depending on the number of bits to be transmitted over the air interface (hereinafter N_{DATA}) and depending on the number of coded bits provided by the channel encoder (systematic bits, 1^{st} parity bits and 2^{nd} parity bits streams).

The bits input to the rate matching function 1 are separated into three different streams in the bit separation module 2. The first stream contains systematic bits, i.e. the unencoded information bits, or, said differently, the number of bits to be encoded. The second one contains the parity bits provided by the first constituent code of a turbo encoder and the third one contains parity bits generated by the second constituent code of the turbo encoder. This operation is done by the bit separation function in the rate matching.

The first rate matching stage 4 can only perform bit puncturing, and only on both parity bits streams. The first systematic bits stream remains unchanged. Its goal is to ensure that the coded block size with which the second rate matching stage 6 can operate, matches the memory size available at the terminal for one HARQ process, indicated by higher layers as N_{IR}. With reference to the virtual IR buffer this means that N_{IR} ≥ N_{sys} + Nₚ₁ + Nₚ₂.

Once the first rate matching stage 4 has generated bits, the second rate matching stage 6 can either puncture or repeat depending on the number of bits collected in the collector 8 and to be sent over the air interface (N_{data}).

The second rate matching stage 6 generates different versions, called "redundancy versions" (RV), of bit vectors in its input based on rate matching (puncturing or repetition) parameters. Said parameters of the second rate matching stage, denoted s, r and b, are grouped to form so-called X_{RV} vectors as listed in tables 1 and 2 below. Xᵣᵥ also serves as a control parameter transmitted by the network to the HSDPA terminals that identifies a redundancy version, that is to say the set of rate matching parameters that a HSDPA terminal shall use for the coding and rate matching processing of the bits that it will receive as part of the HSDPA communication.
■ The parameter s can take the value 0 or 1 to distinguish between transmissions that prioritize systematic bits (s = 1) and non systematic bits (s = 0). For example, when s is set to the value 1 the systematic bits cannot be punctured, whereas if s is set to 0, the systematic bits can be punctured.
■ The parameter r (which ranges from 0 to rₘₐₓ-1) changes the initial error variable eᵢₙᵢ of the rate matching algorithm in the case of puncturing. eᵢₙᵢ is a configuration parameter in the rate matching algorithm described in the above-mentioned TS 25.212 3GPP specification. It influences the puncturing pattern starting position as well as the bit puncturing frequency in the pattern.
■ A third parameter, b, is used for an additional performance enhancement functionality called constellation re-arrangement (CoRe), but only when the 16QAM modulation scheme is used. It consists in rotating 16QAM constellation for balancing so-called Log Likelihood Ratio's (LLR) amplitudes.

The interest of having different puncturing patterns, each generating a redundancy version, is that when retransmissions are combined at the receiver together with the initial transmission, the coding rate is reduced because of the additional redundancy brought by subsequent retransmissions. Therefore a better error correction capability is provided to the decoder.

Tables 1 and 2 below provide examples of the composition of a set of 8 X_{RV} vectors, in the case of a 16QAM modulation, and in the case of a QPSK modulation, respectively.

**Table 1: redundancy versions for 16QAM**

| **X**_{**RV**} | **s** | **R** | **b** |
|---|---|---|---|
| 0 | 1 | 0 | 0 |
| 1 | 0 | 0 | 0 |
| 2 | 1 | 1 | 1 |
| 3 | 0 | 1 | 1 |
| 4 | 1 | 0 | 2 |
| 5 | 1 | 0 | 2 |
| 6 | 1 | 0 | 3 |
| 7 | 1 | 1 | 0 |

**Table 2: redundancy versions for QPSK**

| **X**_{**RV**} | **s** | **R** |
|---|---|---|
| 0 | 1 | 0 |
| 1 | 0 | 0 |
| 2 | 1 | 1 |
| 3 | 0 | 1 |
| 4 | 1 | 2 |
| 5 | 0 | 2 |
| 6 | 1 | 3 |
| 7 | 0 | 3 |

Now referring to Figure 1, N_{SYS} is the number of systematic bits, i.e. the number of bits to be encoded, Nₚ₁ and Nₚ₂ are the number of parity bits in parity bits stream at the output of the first rate matching stage 4 (issued respectively by the first and the second constituent codes of the turbo encoder). Finally, N_{t,sys} corresponds to the number of systematic bits after the second rate matching stage 6, N_{t,p1} to the number of parity 1 bits after the second rate matching stage 6 and N_{t,p2} to the number of parity 2 bits after the second rate matching stage 6.

The output of the first rate matching stage 4 is preferably the minimum between the sum of N_{sys}, Nₚ₁ and Nₚ₂ and N_{IR}, i.e. N_{out_RM1} = min(N_{IR}, N_{sys} + Nₚ₁ + Nₚ₂), as it cannot exceed the size of the terminal memory for the selected HARQ process.

### HSUPA (or Enhanced Uplink) Incremental Redundancy and Rate Matching algorithm in 3GPP Release 6

The 3GPP release 6 rate matching algorithm for HSUPA (also called Enhanced Uplink) is described in the technical report TR 25.808, "FDD Enhanced Uplink, Physical Layer Aspects", Release 6, version 0.2.1, published in October 2004 by the 3GPP. The rate matching algorithm comprises a single stage.

The rate matching function performs either puncturing or repetition, depending on the number of bits to be transmitted over the air interface and depending on the number of coded bits provided by the channel encoder (systematic bits, 1^{st} parity bits and 2^{nd} parity bits streams).

In a similar way to HSDPA, the HSUPA rate matching function generates different versions, also called "redundancy versions" (RV), of bit vectors in its input based on rate matching (puncturing or repetition) parameters. Said parameters of the rate matching, also denoted s and r, are grouped to form X_{RV} vectors as listed in the table 2bis below. Xᵣᵥ also serves as a control parameter transmitted by the network to the HSUPA terminals that identifies a redundancy version, that is to say the set of rate matching parameters that a HSUPA terminal shall use for the coding and rate matching processing of the bits that it will send as part of the HSUPA communication.

Table 2bis below provides examples of the composition of a set of 4 X_{RV} redundancy version vectors. The parameters s and r have the same meaning as what is described above for the QPSK modulation.

**Table 2bis: redundancy versions for HSUPA**

| **X**_{**RV**} | **s** | **R** |
|---|---|---|
| 0 | 1 | 0 |
| 1 | 0 | 0 |
| 2 | 1 | 1 |
| 3 | 0 | 2 |

### Terminal categories and CQI mapping tables

There are 12 HSDPA terminal categories defined in the HSDPA system. These categories can be grouped into 5 pools according to the maximum configuration (modulation and number of spreading codes) they support:
* Categories 1 to 6 (5 codes and 16QAM)
* Categories 7 and 8 (10 codes and 16QAM)
* Category 9 (12 codes and 16QAM)
* Category 10 (15 codes and 16QAM)
* Categories 11 and 12 (5 codes and QPSK only)

For each terminal category group, categories are differentiated by their amount of memory dedicated to HSDPA, as summarized in the following table (and described in the specification TS 25.306, "UE Radio Access Capabilities", v.6.2.0, Release 6, published in June 2004 by the 3GPP):

**Table 3: Terminal categories characteristics**

| **Terminal category** | **Maximum number of bits of an HS-DSCH transport block at the encoder input (Nsysmax)** | **Total number of soft channel bits** |
|---|---|---|
| Category 1 | 7298 | 19200 |
| Category 2 | 7298 | 28800 |
| Category 3 | 7298 | 28800 |
| Category 4 | 7298 | 38400 |
| Category 5 | 7298 | 57600 |
| Category 6 | 7298 | 67200 |
| Category 7 | 14411 | 115200 |
| Category 8 | 14411 | 134400 |
| Category 9 | 20251 | 172800 |
| Category 10 | 27952 | 172800 |
| Category 11 | 3630 | 14400 |
| Category 12 | 3630 | 28800 |

Table 3 contains, for each category, the total amount of memory (total number of soft channel bits) and the maximum size of transport block that can be received i.e. the maximum number of bits at the encoder input.

For an HSDPA session, a maximum of 8 parallel HARQ processes can be configured. One process is a transmission context for a single transport block at a time. In a so-called implicit configuration mode, the memory per process size is uniform among all retransmission processes. For instance, the memory per process corresponds to the total memory of the terminal divided by the number of active processes configured by the UTRAN. A category 5 terminal has a total memory size of 57600 soft channel bits (between a rake receiver and a turbo decoder). With 6 processes configured (which corresponds to the optimal theoretical number of transmission contexts needed in order for a continuous transmission), the memory per process is equal to 9600 bits. This memory per process size corresponds to the N_{IR} value that represents the maximum memory size at the terminal available for a HARQ retransmission process. In a so-called explicit configuration mode, this maximum memory size can be specific to each configured retransmission process, so that it is not necessarily the same for every retransmission process for the HSDPA communication(s) in which a terminal is involved.

As mentioned above, each terminal can indicate to the base station under whose radio coverage it finds itself, by way of the RNC, information concerning its maximum memory size at the terminal available for a HARQ retransmission process. The terminal indicates to the base station its category, from which the base station selects the maximum number of retransmission processes. This number is then relayed to the RNC and confirmed by the RNC to the base station and the terminal. The base station can then determine the maximum memory size at the terminal available for each retransmission process with the terminal.

Tables 4 to 8 are CQI tables for the 5 UE categories groups defined above (see the specification TS 25.214, "Physical Layer Procedures (FDD)", v.5.9.0, Release 5, published by the 3GPP in June 2004). As mentioned above, the CQI indication is periodically transmitted to the base station by the terminal. With each value of CQI is associated a data shaping format, comprising a modulation scheme, a number of spreading codes that can be received simultaneously by the terminal in a TTI, the size of the information block. The base station can derive from information received from a terminal the number of bits to be sent over the air interface parameter (N_{DATA}). For instance, for a QPSK modulation scheme, N_{DATA} = 960 x number of spreading codes(which is a function of the CQI), and for a 16QAM modulation scheme, N_{DATA} = 1920 x number of spreading codes(which is a function of the CQI).

In tables 4 to 8, the value N_{IR} and Xᵣᵥ represent the default value of the maximum memory size at the terminal available for a HARQ retransmission process, and the redundancy version vector index, respectively, that the terminal uses when estimating the CQI to be returned to the base station.

According to one aspect of the invention, to each CQI returned by the terminal there corresponds a preferred or selected HARQ mode, as well as a preferred set of rate-matching parameters. The selection of the preferred set of rate matching parameters is especially important for the first retransmission.

**Table 4: CQI table for terminal categories 1 to 6**

| **CQI value** | **Transport Block Size** | **Number of Spreading Codes** | **Modulation** | **NIR** | **XRV** |
|---|---|---|---|---|---|
| 0 | N/A | Out of range | | | |
| 1 | 137 | 1 | QPSK | 9600 | 0 |
| 2 | 173 | 1 | QPSK | | |
| 3 | 233 | 1 | QPSK | | |
| 4 | 317 | 1 | QPSK | | |
| 5 | 377 | 1 | QPSK | | |
| 6 | 461 | 1 | QPSK | | |
| 7 | 650 | 2 | QPSK | | |
| 8 | 792 | 2 | QPSK | | |
| 9 | 931 | 2 | QPSK | | |
| 10 | 1262 | 3 | QPSK | | |
| 11 | 1483 | 3 | QPSK | | |
| 12 | 1742 | 3 | QPSK | | |
| 13 | 2279 | 4 | QPSK | | |
| 14 | 2583 | 4 | QPSK | | |
| 15 | 3319 | 5 | QPSK | | |
| 16 | 3565 | 5 | 16-QAM | | |
| 17 | 4189 | 5 | 16-QAM | | |
| 18 | 4664 | 5 | 16-QAM | | |
| 19 | 5287 | 5 | 16-QAM | | |
| 20 | 5887 | 5 | 16-QAM | | |
| 21 | 6554 | 5 | 16-QAM | | |
| 22 | 7168 | 5 | 16-QAM | | |
| 23 | 7168 | 5 | 16-QAM | | |
| 24 | 7168 | 5 | 16-QAM | | |
| 25 | 7168 | 5 | 16-QAM | | |
| 26 | 7168 | 5 | 16-QAM | | |
| 27 | 7168 | 5 | 16-QAM | | |
| 28 | 7168 | 5 | 16-QAM | | |
| 29 | 7168 | 5 | 16-QAM | | |
| 30 | 7168 | 5 | 16-QAM | | |

**Table 5: CQI table for terminal categories 7 and 8**

| **CQI value** | **Transport Block Size** | **Number of Spreading Codes** | **Modulation** | **NIR** | **XRV** |
|---|---|---|---|---|---|
| 0 | N/A | Out of range | | | |
| 1 | 137 | 1 | QPSK | 19200 | 0 |
| 2 | 173 | 1 | QPSK | | |
| 3 | 233 | 1 | QPSK | | |
| 4 | 317 | 1 | QPSK | | |
| 5 | 377 | 1 | QPSK | | |
| 6 | 461 | 1 | QPSK | | |
| 7 | 650 | 2 | QPSK | | |
| 8 | 792 | 2 | QPSK | | |
| 9 | 931 | 2 | QPSK | | |
| 10 | 1262 | 3 | QPSK | | |
| 11 | 1483 | 3 | QPSK | | |
| 12 | 1742 | 3 | QPSK | | |
| 13 | 2279 | 4 | QPSK | | |
| 14 | 2583 | 4 | QPSK | | |
| 15 | 3319 | 5 | QPSK | | |
| 16 | 3565 | 5 | 16-QAM | | |
| 17 | 4189 | 5 | 16-QAM | | |
| 18 | 4664 | 5 | 16-QAM | | |
| 19 | 5287 | 5 | 16-QAM | | |
| 20 | 5887 | 5 | 16-QAM | | |
| 21 | 6554 | 5 | 16-QAM | | |
| 22 | 7168 | 5 | 16-QAM | | |
| 23 | 9719 | 7 | 16-QAM | | |
| 24 | 11418 | 8 | 16-QAM | | |
| 25 | 14411 | 10 | 16-QAM | | |
| 26 | 14411 | 10 | 16-QAM | | |
| 27 | 14411 | 10 | 16-QAM | | |
| 28 | 14411 | 10 | 16-QAM | | |
| 29 | 14411 | 10 | 16-QAM | | |
| 30 | 14411 | 10 | 16-QAM | | |

**Table 6: CQI table for terminal category 9**

| **CQI value** | **Transport Block Size** | **Number of Spreading** | **Modulation** | **NIR** | **XRV** |
|---|---|---|---|---|---|
| 0 | N/A | Out of range | | | |
| 1 | 137 | 1 | QPSK | 28800 | 0 |
| 2 | 173 | 1 | QPSK | | |
| 3 | 233 | 1 | QPSK | | |
| 4 | 317 | 1 | QPSK | | |
| 5 | 377 | 1 | QPSK | | |
| 6 | 461 | 1 | QPSK | | |
| 7 | 650 | 2 | QPSK | | |
| 8 | 792 | 2 | QPSK | | |
| 9 | 931 | 2 | QPSK | | |
| 10 | 1262 | 3 | QPSK | | |
| 11 | 1483 | 3 | QPSK | | |
| 12 | 1742 | 3 | QPSK | | |
| 13 | 2279 | 4 | QPSK | | |
| 14 | 2583 | 4 | QPSK | | |
| 15 | 3319 | 5 | QPSK | | |
| 16 | 3565 | 5 | 16-QAM | | |
| 17 | 4189 | 5 | 16-QAM | | |
| 18 | 4664 | 5 | 16-QAM | | |
| 19 | 5287 | 5 | 16-QAM | | |
| 20 | 5887 | 5 | 16-QAM | | |
| 21 | 6554 | 5 | 16-QAM | | |
| 22 | 7168 | 5 | 16-QAM | | |
| 23 | 9719 | 7 | 16-QAM | | |
| 24 | 11418 | 8 | 16-QAM | | |
| 25 | 14411 | 10 | 16-QAM | | |
| 26 | 17237 | 12 | 16-QAM | | |
| 27 | 17237 | 12 | 16-QAM | | |
| 28 | 17237 | 12 | 16-QAM | | |
| 29 | 17237 | 12 | 16-QAM | | |
| 30 | 17237 | 12 | 16-QAM | | |

**Table 7: CQI table for terminal category 10**

| **CQI value** | **Transport Block Size** | **Number of Spreading Codes** | **Modulation** | **NIR** | **XRV** |
|---|---|---|---|---|---|
| 0 | N/A | Out of range | | | |
| 1 | 137 | 1 | QPSK | 28800 | 0 |
| 2 | 173 | 1 | QPSK | | |
| 3 | 233 | 1 | QPSK | | |
| 4 | 317 | 1 | QPSK | | |
| 5 | 377 | 1 | QPSK | | |
| 6 | 461 | 1 | QPSK | | |
| 7 | 650 | 2 | QPSK | | |
| 8 | 792 | 2 | QPSK | | |
| 9 | 931 | 2 | QPSK | | |
| 10 | 1262 | 3 | QPSK | | |
| 11 | 1483 | 3 | QPSK | | |
| 12 | 1742 | 3 | QPSK | | |
| 13 | 2279 | 4 | QPSK | | |
| 14 | 2583 | 4 | QPSK | | |
| 15 | 3319 | 5 | QPSK | | |
| 16 | 3565 | 5 | 16-QAM | | |
| 17 | 4189 | 5 | 16-QAM | | |
| 18 | 4664 | 5 | 16-QAM | | |
| 19 | 5287 | 5 | 16-QAM | | |
| 20 | 5887 | 5 | 16-QAM | | |
| 21 | 6554 | 5 | 16-QAM | | |
| 22 | 7168 | 5 | 16-QAM | | |
| 23 | 9719 | 7 | 16-QAM | | |
| 24 | 11418 | 8 | 16-QAM | | |
| 25 | 14411 | 10 | 16-QAM | | |
| 26 | 17237 | 12 | 16-QAM | | |
| 27 | 21754 | 15 | 16-QAM | | |
| 28 | 23370 | 15 | 16-QAM | | |
| 29 | 24222 | 15 | 16-QAM | | |
| 30 | 25558 | 15 | 16-QAM | | |

**Table 8: CQI table for terminal categories 11 and 12**

| **CQI value** | **Transport Block Size** | **Number of Spreading Codes** | **Modula tion** | **NIR** | **XRV** |
|---|---|---|---|---|---|
| 0 | N/A | Out of range | | | |
| 1 | 137 | 1 | QPSK | 4800 | 0 |
| 2 | 173 | 1 | QPSK | | |
| 3 | 233 | 1 | QPSK | | |
| 4 | 317 | 1 | QPSK | | |
| 5 | 377 | 1 | QPSK | | |
| 6 | 461 | 1 | QPSK | | |
| 7 | 650 | 2 | QPSK | | |
| 8 | 792 | 2 | QPSK | | |
| 9 | 931 | 2 | QPSK | | |
| 10 | 1262 | 3 | QPSK | | |
| 11 | 1483 | 3 | QPSK | | |
| 12 | 1742 | 3 | QPSK | | |
| 13 | 2279 | 4 | QPSK | | |
| 14 | 2583 | 4 | QPSK | | |
| 15 | 3319 | 5 | QPSK | | |
| 16 | 3319 | 5 | QPSK | | |
| 17 | 3319 | 5 | QPSK | | |
| 18 | 3319 | 5 | QPSK | | |
| 19 | 3319 | 5 | QPSK | | |
| 20 | 3319 | 5 | QPSK | | |
| 21 | 3319 | 5 | QPSK | | |
| 22 | 3319 | 5 | QPSK | | |
| 23 | 3319 | 5 | QPSK | | |
| 24 | 3319 | 5 | QPSK | | |
| 25 | 3319 | 5 | QPSK | | |
| 26 | 3319 | 5 | QPSK | | |
| 27 | 3319 | 5 | QPSK | | |
| 28 | 3319 | 5 | QPSK | | |
| 29 | 3319 | 5 | QPSK | | |
| 30 | 3319 | 5 | QPSK | | |

The default HARQ type specified in the HSDPA technical specification is Chase Combining (CC), i.e. a pure repetition mode with optimum combination of retransmissions by the terminal.

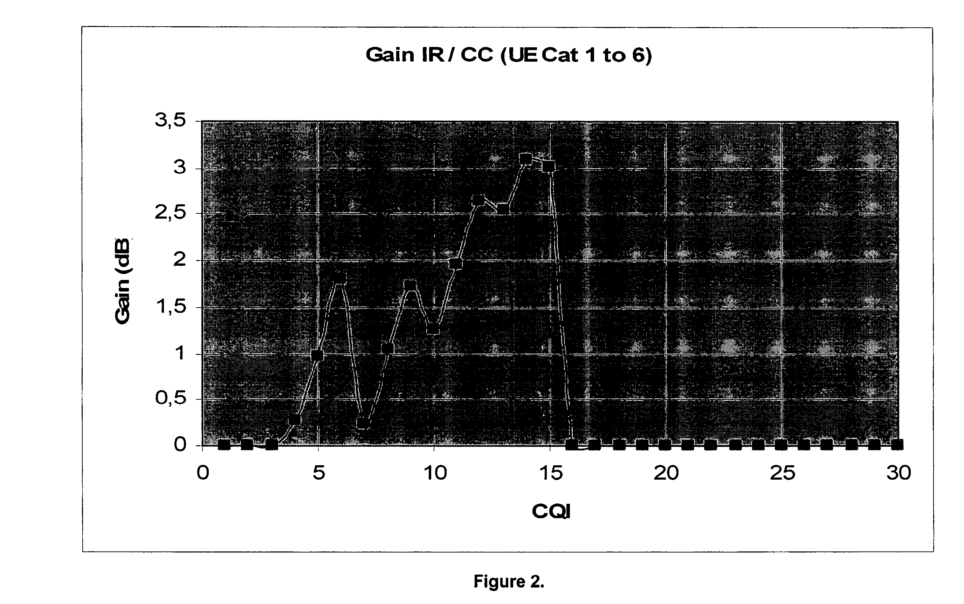

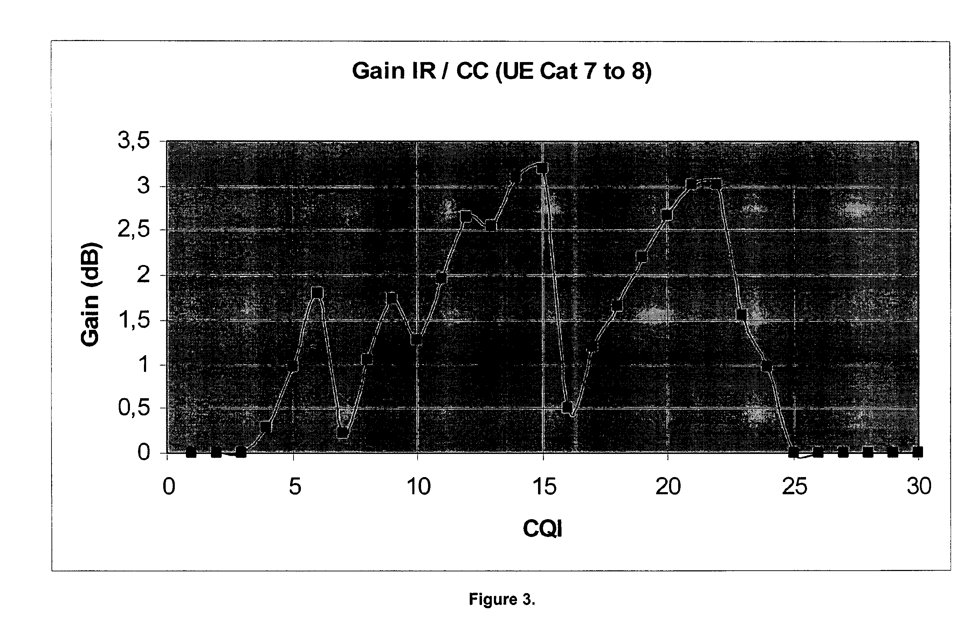

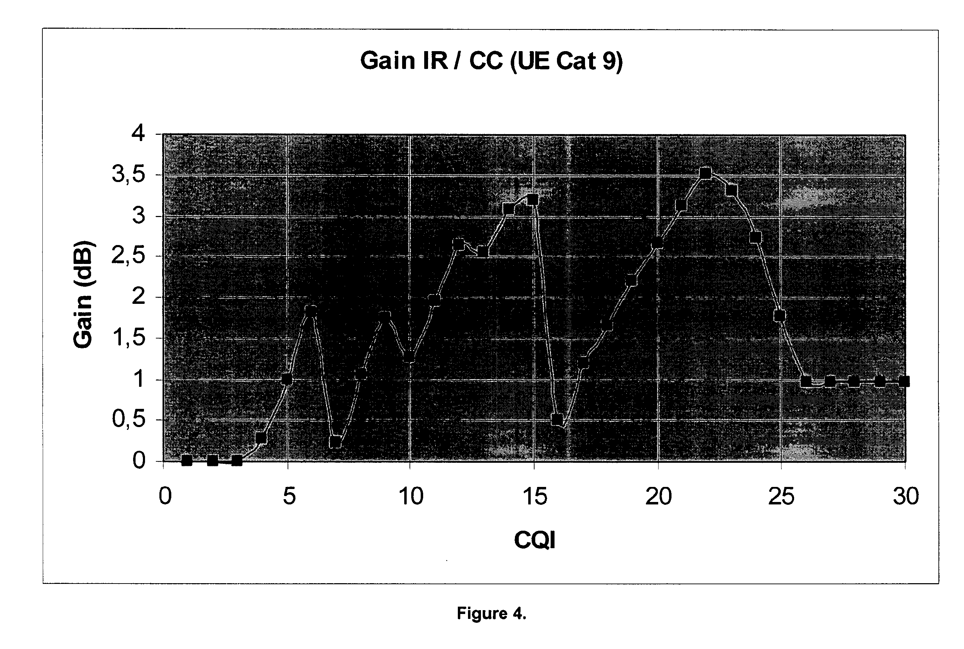

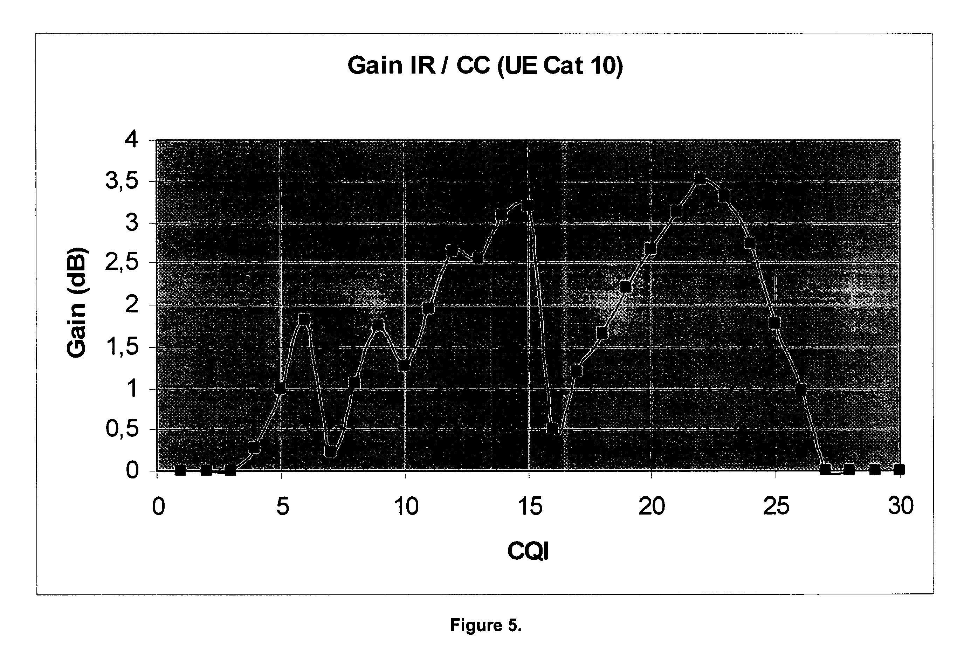

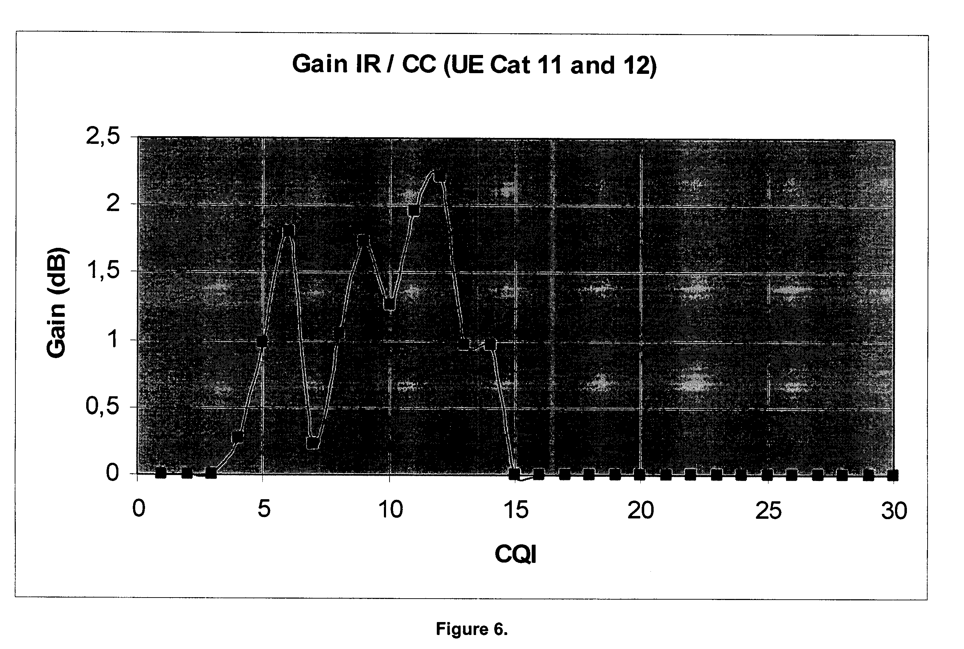

Figures 2 to 6 illustrate, on an AWGN channel, the gain that can be expected from using Incremental Redundancy (IR) instead of CC for each terminal category group. As depicted in Figures 2 to 6, IR can bring an important performance improvement for some CQI, but is useless for others compared to CC. These figures also show that using IR systematically instead of CC never degrades performance. The performance tests have been completed and are illustrated for a configuration that conforms to the test specification TS 34.108 ("Technical Specification Group Terminals; Common test environments for User Equipment (UE); Conformance Testing", Release 5, v. 5.2.0., published in September 2004, by the 3GPP) with the above-mentioned implicit configuration mode with regard to the memory per process size.

On the contrary, when IR does not bring any gain, CPU resources can be saved at the base station by configuring CC instead of IR. As CC is a pure repetition mode, the puncturing or repetition pattern remains the same for all retransmission as the one used for the initial transmission. With IR, this puncturing or repetition pattern changes each time the block is retransmitted.

This clearly illustrates how advantageous a dynamic retransmission mode selection method can be over a static, or preconfigured one.

### Algorithm for HSDPA

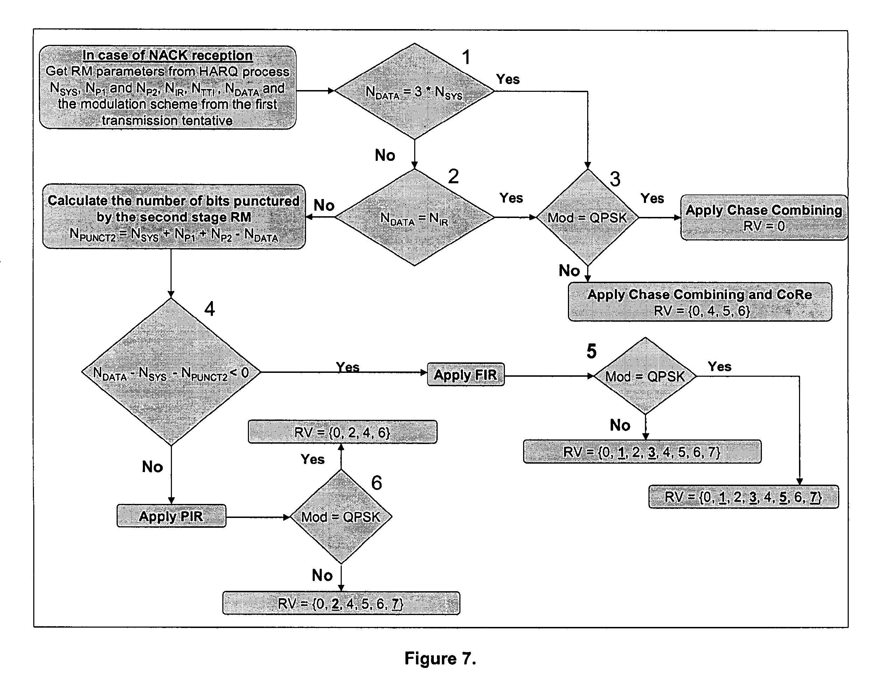

Referring now to Figure 7, a block diagram is shown of a method provided by a preferred embodiment of the invention in the case of a HSDPA transmission.

It is assumed that a negative acknowledgment has been received for data which shall therefore have to be retransmitted according to a retransmission mode. This data will have been transmitted using a redundancy version vector. Typically, such data was first transmitted using the redundancy version vector Xᵣᵥ(0) by default.

The comparison (block 1 on figure 7) of the number of systematic bits to the number of bits to be sent over the air interface comprises a comparison of the overall coding rate (N_{SYS}/N_{DATA}) to the error correcting encoding rate. With a 1/n error correcting encoding rate, the number of bits output by the encoder equals n times the number of bits input to the encoder (number of systematic bits). In a case where the error correcting scheme is turbo coding, the encoding rate is termed turbo coding rate. The specified HSDPA turbo coder has a coding rate of 1/3.

If the overall coding rate is smaller than the turbo code rate, repetition has to be performed by the second stage of the rate matching process and chase combining, possibly combined with CoRe for a 16QAM modulation, is applied. The selection (block 3 on figure 7) of the rate matching parameters - i.e. the redundancy version vector X_{RV}(i) - that can be used for the retransmissions is then completed on the base of the transmission modulation scheme. The retransmission scheme in accordance with an embodiment of the present invention comprises:
- if the transmission modulation scheme is QPSK, only X_{RV}(0) for QPSK (see table 1) will be used, that is s = 1, r = 0;
- if the transmission modulation scheme is 16QAM, only X_{RV}(0), X_{RV}(4), X_{RV}(5), X_{RV}(6) for 16QAM (see table 2) will be used, that is (s=1, r=0, b=0), (s=1, r=0, b=1), (s=1, r=0, b=2) or (s=1, r=0, b=3), respectively. For these 4 sets of rate matching parameters, the parameters s and r of the second stage of the rate matching process have the same values, 1 and 0 respectively. The four corresponding redundancy versions differ in the constellation rotation index, coded in the CoRe parameter b. Therefore the first two parameters, s and r, are set to the same values as for a QPSK transmission modulation scheme, and the difference with QPSK is the availability with 16QAM of the CoRe scheme which provides an additional improvement to the overall performances.

If the overall coding rate is not smaller than the turbo code rate, the number of bits to be sent over the air interface (N_{DATA}) is compared to the maximum memory size at the receiver unit available for a HARQ retransmission process (N_{IR}) (block 2 on figure 7).

If the number of bits to be sent over the air interface (N_{DATA}) is greater than the maximum memory size at the receiver unit available for a HARQ retransmission process (N_{IR}), the first stage of the rate matching process will puncture bits up to the maximum memory size at the receiver unit available for a HARQ retransmission process (N_{IR}) and the second stage will have to repeat some bits to match the number of bits to be sent over the air interface (N_{DATA}). In such case chase combining, optionally combined with CoRe for a 16QAM modulation, is applied. The selection (block 3 on figure 7) of the rate matching parameters - i.e. the redundancy version vector X_{RV}(i) - that can be used for the retransmissions is then completed on the base of the transmission modulation scheme in the same way as previously described:
- if the transmission modulation scheme is QPSK, only X_{RV}(0) for QPSK (see table 1) will be used, that is s = 1, r = 0. Alternatively, assuming that the data to be retransmitted would have been first transmitted using the redundancy version vector Xᵣᵥ(i), where i=2, 4 or 6, the same redundancy version vector as the initial one could be used for the retransmissions. The main requirement is to use only one redundancy version for the first and successive transmissions for which s=1;
- if the transmission modulation scheme is 16QAM, only X_{RV}(0), X_{RV}(4), X_{RV}(5), X_{RV}(6) for 16QAM (see table 2) will be used, that is (s=1, r=0, b=0), (s=1, r=0, b=1), (s=1, r=0, b=2) or (s=1, r=0, b=3), respectively. For these 4 sets of rate matching parameters, the parameters s and r of the second stage of the rate matching process have the same values, 1 and 0 respectively. The four corresponding redundancy versions differ in the constellation rotation index, coded in the CoRe parameter b. Therefore the first two parameters, s and r, are set to the same values as for a QPSK transmission modulation scheme, and the difference with QPSK is the availability with 16QAM of the CoRe scheme which provides an additional improvement to the overall performances. Alternatively, assuming that the data to be retransmitted would have been first transmitted using the redundancy version vector Xᵣᵥ(i), where i=2 or 7, the same redundancy version vector as the initial one could be used for the retransmissions.

If the overall coding rate is not smaller than the turbo code rate, and the number of bits to be sent over the air interface (N_{DATA}) is not greater than the maximum memory size at the receiver unit available for a HARQ retransmission process (N_{IR}), an incremental redundancy retransmission scheme is selected.

In order to complete such selection between HARQ mode 2, i.e. Full Incremental Redundancy (FIR) and HARQ mode 3, i.e. Partial Incremental Redundancy (PIR), the number of bits to be punctured by the second stage of the HSDPA rate matching process (N_{PUNCT2}) is calculated: N_{PUNCT2} = N_{SYS} + N_{P1} + N_{P2} - N_{DATA}.

This calculated number of parity bits to be punctured by the second stage of the rate matching process (N_{PUNCT2}) is compared to the number of bits, exclusive of the number of systematic bits (N_{SYS}), to be sent over the air interface, i.e. N_{DATA} minus N_{SYS}. - block 4 on figure 7.

If the number of parity bits to be punctured by the second stage of the rate matching process (N_{PUNCT2}) is larger than the number of bits, exclusive of the number of systematic bits (N_{SYS}), to be sent over the air interface, HARQ mode 3 (Full Incremental Redundancy) is selected. Otherwise HARQ mode 2 (Partial Incremental Redundancy) is selected instead.

In the case of Full Incremental Redundancy (FIR) selection:

Any redundancy version may be used, and the full set of redundancy vectors X_{RV}(i), i = 0 to 7 that corresponds to the transmission modulation scheme is available (block 5 on figure 7). Furthermore, preferred sets of rate matching parameters (indicated in bold on Figure 7) are identified for the first retransmission.
- if the transmission modulation scheme is QPSK, the preferred sets are X_{RV}(1), X_{RV}(3), X_{RV}(5) and X_{RV}(7), that is (s=0, r=0), (s=0, r=1), (s=0, r=2) and (s=0, r=3), respectively;
- if the transmission modulation scheme is 16QAM, the preferred sets are X_{RV}(1) and X_{RV}(3), that is (s=0, r=0, b=0) and (s=0, r=1, b=1), respectively.

In the case of Partial Incremental Redundancy (PIR) selection:

The selection (block 6 on figure 7) of the rate matching parameters - i.e. the redundancy version vector X_{RV}(i) - that can be used for the retransmissions is then completed on the base of the transmission modulation scheme:
- if the transmission modulation scheme is QPSK, only X_{RV}(0), X_{RV}(2), X_{RV}(4), X_{RV}(6) for QPSK (see table 1) can be used, that is (s=1, r=0), 2 (s=1, r=1), 4 (s=1, r=2), or 6 (s=1, r=3), respectively, as puncturing of systematic bits (s=0) is not an option in the PIR mode;
- if the transmission modulation scheme is 16QAM, only X_{RV}(0), X_{RV}(2), X_{RV}(4), X_{RV}(5), X_{RV}(6) or X_{RV}(7) for 16QAM (see table 2) will be used, that is (s=1, r=0, b=0), (s=1, r=1, b=1), (s=1, r=0, b=1), (s=1, r=0, b=2), (s=1, r=0, b=3) or (s=1, r=1, b=0), respectively. Likewise, only redundancy version vectors for which s = 1 can be used in PIR. Furthermore, preferred sets of rate matching parameters (indicated in bold on Figure 7) are identified for the first retransmission. In such case, the preferred sets are X_{RV}(2) and X_{RV}(7), that is (s=1, r=1, b=1) and (s=1, r=1, b=0), respectively.

### Algorithm for HSUPA

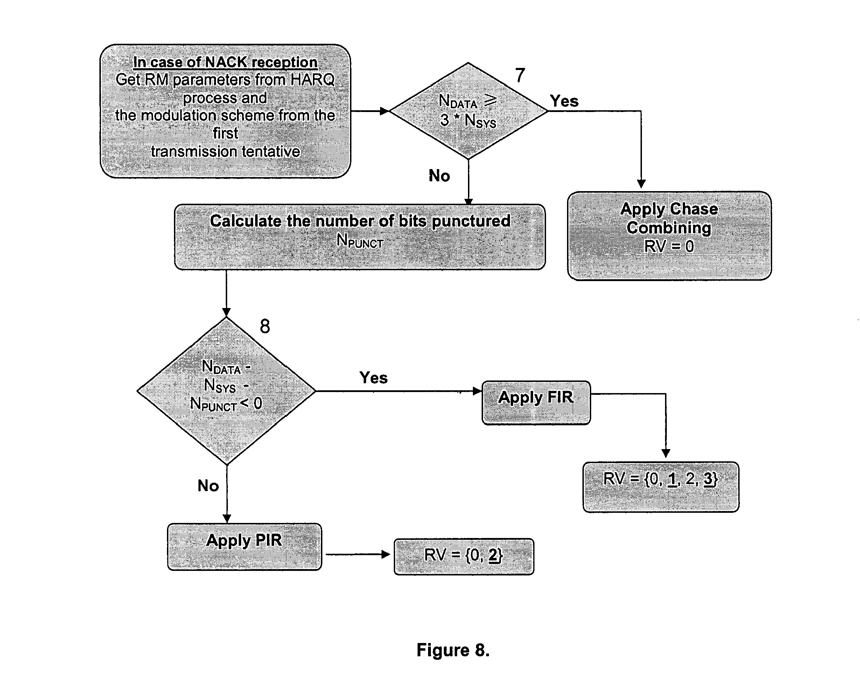

Referring now to Figure 8, a block diagram is shown of method provided by a preferred embodiment of the invention in the case of a HSUPA transmission.

It is assumed that a negative acknowledgment has been received for data which shall therefore be retransmitted according to a retransmission mode.

The comparison (block 7 on figure 8) of the number of systematic bits to the number of bits to be sent over the air interface comprises a comparison of the overall coding rate (N_{SYS}/N_{DATA}) to the encoding rate. In a case where the error correcting scheme is turbo coding, the encoding rate is the turbo coding rate, and equals 1/3.

If the overall coding rate is greater than the turbo code rate, repetition has to be performed by the rate matching process and chase combining is applied. The redundancy version vector X_{RV}(0) (see table 2bis) is selected for the retransmissions

If the overall coding rate is not greater than the turbo code rate, an incremental redundancy retransmission scheme is selected.

In order to complete such selection between HARQ mode 2, i.e. Full Incremental Redundancy (FIR) and HARQ mode 3, i.e. Partial Incremental Redundancy (PIR), the number of bits to be punctured by the HSUPA rate matching process is calculated.

This calculated number of parity bits to be punctured by the rate matching process is compared to the number of bits, exclusive of the number of systematic bits (N_{SYS}), to be sent over the air interface, i.e. N_{DATA} minus N_{SYS}. - block 8 on figure 8.

If the number of parity bits to be punctured by the rate matching process is larger than the number of bits, exclusive of the number of systematic bits (N_{SYS}), to be sent over the air interface, HARQ mode 3 (Full Incremental Redundancy) is selected. Otherwise HARQ mode 2 (Partial Incremental Redundancy) is selected instead.

In the case of Full Incremental Redundancy (FIR) selection:
Any redundancy version may be used, and the full set of redundancy vectors X_{RV}(i), i = 0 to 3 is available. Furthermore, preferred sets of rate matching parameters are identified for the first retransmission. These are X_{RV}(1) and
X_{RV}(3), that is (s=0, r=0) and (s=0, r=2), respectively;

In the case of Partial Incremental Redundancy (PIR) selection:
The selection of the rate matching parameters - i.e. the redundancy version vector X_{RV}(i) - that can be used for the retransmissions is then completed on the base of the transmission modulation scheme, i.e. QPSK: only X_{RV}(0) and X_{RV}(2) can be used, that is (s=1, r=0), 2 (s=1, r=1), respectively, as puncturing of systematic bits (s=0) is not an option in the PIR mode. Furthermore, a preferred set of rate matching parameters, X_{RV}(2), that is (s=1, r=1), is identified for the first retransmission.

### Illustration

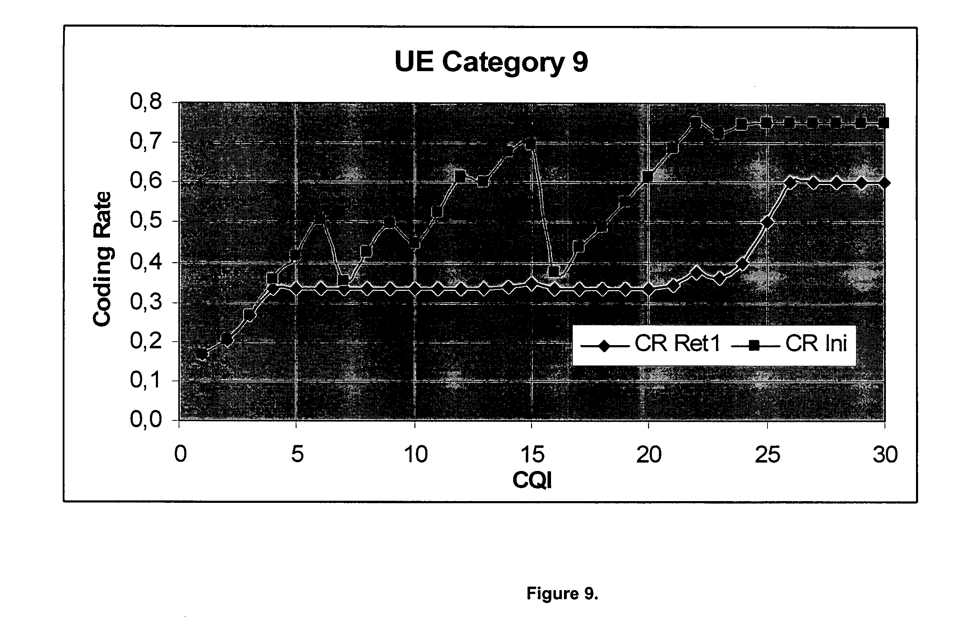

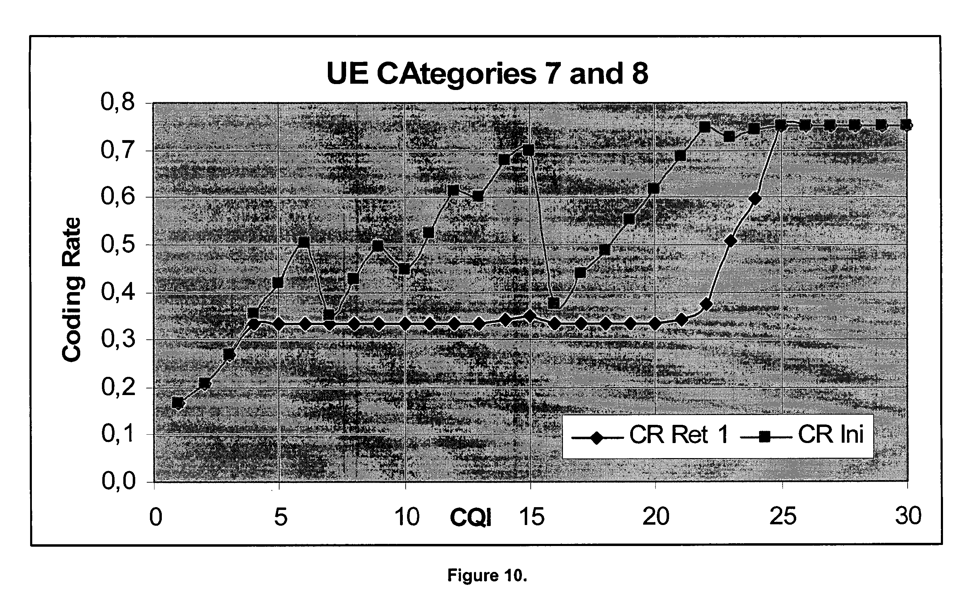

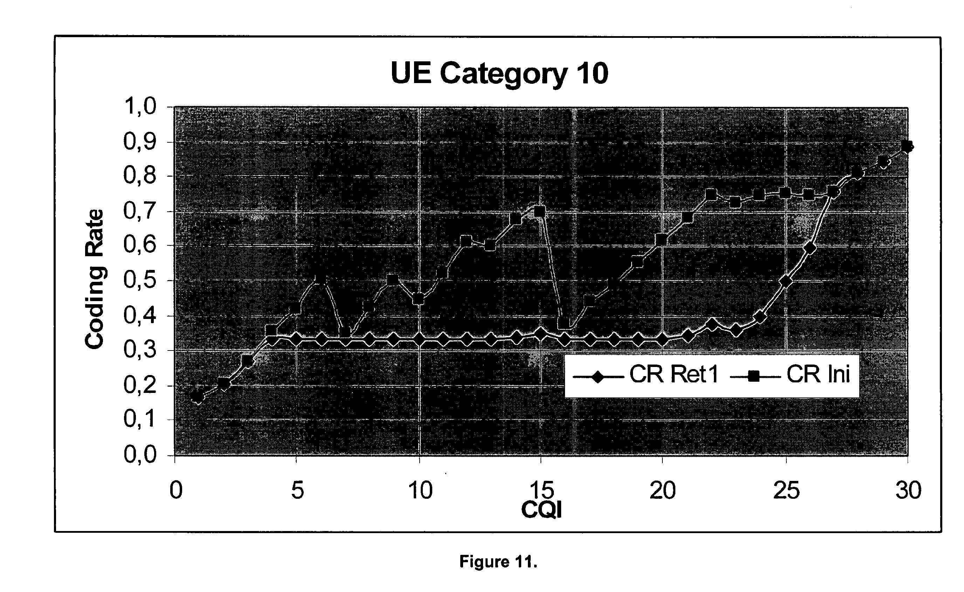

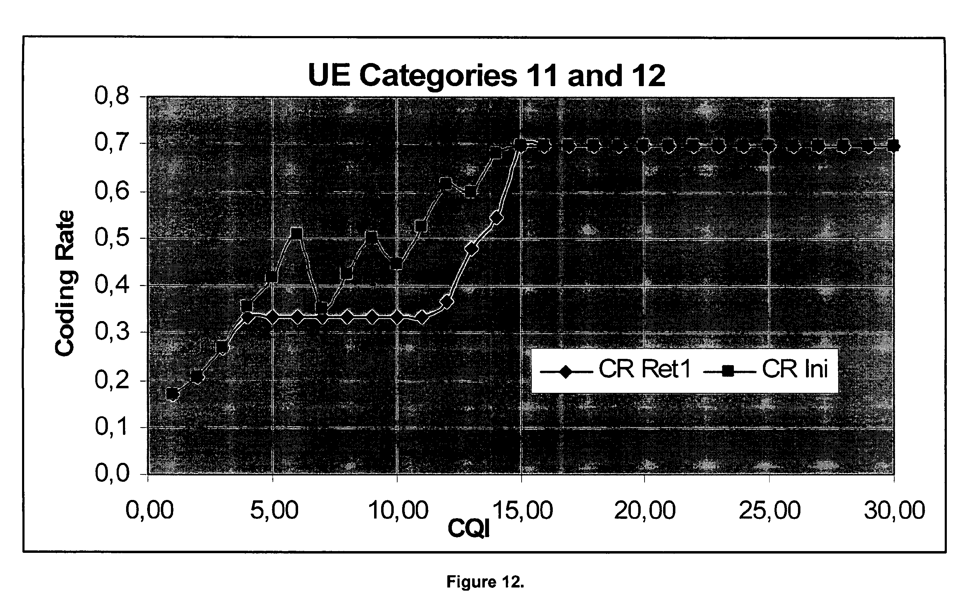

The five terminal categories groups are considered on figures 9 to 12, respectively, with default memory size N_{IR} values defined as reference in each terminal categories group CQI table. Figures 9 to 12 illustrate the coding gain provided by incremental redundancy between the first transmission and the first retransmission.

### Implementation

The present invention may be implemented in hardware or, for example, in software using a processing engine such as a microprocessor or a programmable logic device (PLD's) such as a PLA (programmable logic array), PAL (programmable array logic), FPGA (field programmable gate array).

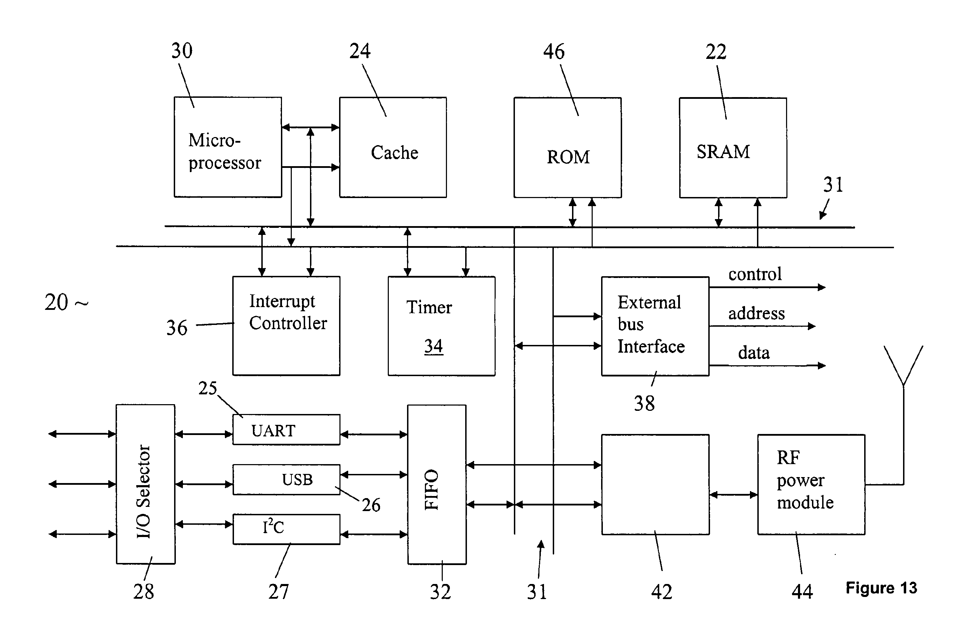

An example of a circuit 20 with an embedded processor will be described with reference to Fig. 13 for use in a base station or a mobile radio telephone receiver/transmitter. This circuit 20 may be constructed as a VLSI chip around an embedded microprocessor 30 such as an ARM7TDMI core designed by ARM Ltd., UK which may be synthesized onto a single chip with the other components shown. A zero wait state SRAM memory 22 may be provided on-chip as well as a cache memory 24. Various I/O (input/output) interfaces 25, 26, 27 may be provided, e.g. UART, USB, I²C bus interface as well as an I/O selector 28 for receiving data bits from a suitable source, e.g. a data or speech source. FIFO buffers 32 may be used to decouple the processor 30 from data transfer through these interfaces. A counter/timer block 34 may be provided as well as an interrupt controller 36. The interface to the radio frequency part is provided by block 42 which can be used for transmitting to, and receiving from the radio frequency power module 44. For the base station example, the block 42 could also handle the multiplexing and demultiplexing of multi-user baseband data. In receive mode, baseband data received by block 42 is passed to the processor 30 for processing.

Software programs may be stored in an internal ROM (read only memory) 46 and/or may be stored in an external memory. Access to an external memory may be provided an external bus interface 38 with address, data and control busses.

The various blocks of circuit 20 are linked by suitable busses 31. The control mechanisms of the present invention may be implemented as software to run on processor 30. In particular a dynamic retransmission mode selector in accordance with the present invention may be implemented by suitable programming of the processor 30. The methods and procedures described above may be written as computer programs in a suitable computer language such as C and then compiled for the specific processor in the embedded design. For example, for the embedded ARM core VLSI described above the software may be written in C and then compiled using the ARM C compiler and the ARM assembler. The software may include code for selecting a retransmission mode. The base station of mobile unit has means for the transmission of data over an air interface. It is assumed that data have been first transmitted in acknowledged mode between a transmitter unit and a receiver unit and no positive acknowledgement of said first transmission has been received at the transmitter unit. The base station or mobile unit also has means for the data being processed according to an error correcting encoding scheme prior to transmission over the interface. The software code, which when executed on a processing engine, includes means for first comparing the number of bits to be encoded (N_{SYS}) and the number of bits to be sent over the interface (N_{DATA}); and means for determining, responsive to said first comparison, a type of retransmission mode for the retransmission of the first transmitted data. The code may also include means for a second comparing of a number of bits representative of an available memory size at the receiver unit (N_{IR}) and the number of bits to be sent over the air interface (N_{DATA}); and means for determining, responsive to said first and second comparisons, a type of retransmission mode for the retransmission of the first transmitted data. The software code having means for determining a type of retransmission mode may comprise means determining whether the retransmission of data may be done according to an incremental redundancy scheme. The software code for the second comparing may comprise means for a comparison of a number of bits representing a maximum memory size at the receiver unit available for a retransmission process (N_{IR}), with the number of bits to be sent over the interface (N_{DATA}). The software code having the means for first comparing of the number of bits to be encoded (N_{SYS}) and the number of bits to be sent over the interface (N_{DATA}) may comprise means for comparing the overall coding rate (N_{SYS}/N_{DATA}) to the error correcting encoding rate (1/n). The software code for the determining of a type of retransmission mode may comprise means for excluding an incremental redundancy retransmission scheme if the overall coding rate (N_{SYS}/N_{DATA}) is smaller than the error correcting encoding rate (1/n). The software code for the determining of a type of retransmission mode may comprise means for excluding an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is smaller than the number of bits to be sent over the interface (N_{DATA}). The software code including the means for determining a type of retransmission mode may comprise means for selecting an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is greater than the number of bits to be sent over the interface (N_{DATA}).
In the embodiment where the data is processed according to the error correcting encoding scheme and a rate matching scheme prior to transmission over the interface, the software code may also include means for calculating a number (N_{PUNCT2}) of bits to be punctured in order to match the number of bits to be sent over the interface (N_{DATA}); and means for third comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}); and means for selecting, responsive to said third comparison, an incremental redundancy scheme for the retransmission of the first transmitted data.

In a further embodiment software code may be provided for selecting an incremental redundancy retransmission scheme, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme and a rate matching scheme prior to transmission over the interface. The software code, when executed on a processing engine, has means for determining whether the retransmission of data may be done according to an incremental redundancy retransmission scheme; means for calculating a number (N_{PUNCT2}) of bits to be punctured in order to match the number of bits to be sent over the interface (N_{DATA}); means for comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}); and means for selecting, responsive to said comparison, an incremental redundancy scheme for the retransmission of the first transmitted data. The means for selecting of an incremental redundancy scheme for the retransmission of data may comprise means for selecting the Full Incremental Redundancy mode or the Partial Incremental Redundancy Mode. The means for selecting of an incremental redundancy scheme for the retransmission of data, may comprise means for selecting a predetermined incremental redundancy scheme for the retransmission of data if the number of bits, exclusive of the number of bits to be encoded (N_{SYS}), to be sent over the interface (N_{DATA} - N_{SYS}) is smaller than said number (N_{PUNCT2}) of bits to be punctured in order to match the number of bits to be sent over the interface (N_{DATA}). The means for selecting an incremental redundancy scheme for the retransmission of data, may comprise means for selecting a predetermined incremental redundancy scheme for the retransmission of data if the number of bits, exclusive of the number of bits to be encoded (N_{SYS}), to be sent over the interface (N_{DATA} - N_{SYS}) is greater than said number (N_{PUNCT2}) of bits to be punctured in order to match the number of bits to be sent over the interface (N_{DATA}).

Alternatively, a dynamic retransmission mode selector in accordance with the present invention may be implemented in block 42 which then co-operates with the processor 30 to provide the retransmission mode selection. In this case the block 42 includes the means defined above for the software code.

## Claims

1. A method of selecting a retransmission mode, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme prior to transmission over the interface, the method comprising:
- first comparing the number of bits to be encoded (N_{SYS}) and the number of bits to be sent over the interface (N_{DATA}); and
- determining, responsive to said first comparison, a type of retransmission mode for the retransmission of the first transmitted data.

2. A method according to claim 1, which further comprises:
- second comparing a number of bits representative of an available memory size at the receiver unit (N_{IR}) and the number of bits to be sent over the air interface (N_{DATA}); and
- determining, responsive to said first and second comparisons, a type of retransmission mode for the retransmission of the first transmitted data.

3. A method according to claim 1 or 2, wherein the determining a type of retransmission mode comprises determining whether the retransmission of data may be done according to an incremental redundancy scheme.

4. A method according to claim 2, herein the second comparing comprises a comparison of a number of bits representing a maximum memory size at the receiver unit available for a retransmission process (N_{IR}), with the number of bits to be sent over the interface (N_{DATA}).

5. A method according to any of the preceding claims, herein the first comparing of the number of bits to be encoded (N_{SYS}) and the number of bits to be sent over the interface (N_{DATA}) comprises comparing the overall coding rate (N_{SYS}/N_{DATA}) to the error correcting encoding rate (1/n).

6. A method according to claim 5, wherein the determining of a type of retransmission mode comprises: excluding an incremental redundancy retransmission scheme if the overall coding rate (N_{SYS}/N_{DATA}) is smaller than the error correcting encoding rate (1/n).

7. A method according to any of the claims 4 to 7, wherein the determining of a type of retransmission mode comprises: excluding an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is smaller than the number of bits to be sent over the interface (N_{DATA}).

8. A method according to any of the claims 4 to 7, herein the determining of a type of retransmission mode comprises: selecting an incremental redundancy retransmission scheme if the overall coding rate (N_{SYS}/N_{DATA}) is greater than the error correcting encoding rate (1/n) and the number of bits representing a maximum memory size at the receiver unit available for a retransmission process (N_{IR}) is greater than the number of bits to be sent over the interface (N_{DATA}).

9. A method according to any of claims 5 to 8, in which the error correcting scheme is turbo coding, and the error correcting encoding rate (1/n) equals 1/3.

10. A method according to any of the preceding claims, the data being processed according to the error correcting encoding scheme and a rate matching scheme prior to transmission over the interface, the method further comprising:
- calculating a number (N_{PUNCT2}) of bits to be punctured in order to match the number of bits to be sent over the interface (N_{DATA});
- third comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA});
- selecting, responsive to said third comparison, an incremental redundancy scheme for the retransmission of the first transmitted data.

11. A method of selecting an incremental redundancy retransmission scheme, for the transmission of data which have been first transmitted in acknowledged mode between a transmitter unit and a receiver unit over an interface, and for which no positive acknowledgement of said first transmission has been received at the transmitter unit, the data being processed according to an error correcting encoding scheme and a rate matching scheme prior to transmission over the interface, the method comprising:
- determining whether the retransmission of data may be done according to an incremental redundancy retransmission scheme;
- calculating a number (N_{PUNCT2}) of bits to be punctured in order to match the number of bits to be sent over the interface (N_{DATA});
- comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA}); and
- selecting, responsive to said comparison, an incremental redundancy scheme for the retransmission of the first transmitted data.

12. A method according to claim 10 or 11, in which the selecting of an incremental redundancy scheme for the retransmission of data comprises selecting the Full Incremental Redundancy mode or the Partial Incremental Redundancy Mode.

13. A method, according to any of the claims 10 to 12, herein the selecting of an incremental redundancy scheme for the retransmission of data, comprises selecting a predetermined incremental redundancy scheme for the retransmission of data if the number of bits, exclusive of the number of bits to be encoded (N_{SYS}), to be sent over the interface (N_{DATA} - N_{SYS}) is smaller than said number (N_{PUNCT2}) of bits to be punctured in order to match the number of bits to be sent over the interface (N_{DATA}).

14. A method, according to claim 13, in which said selected predetermined incremental redundancy scheme is Full Incremental Redundancy.

15. A method, according to any of the claims 10 to 12, in which the selecting of an incremental redundancy scheme for the retransmission of data, comprises selecting a predetermined incremental redundancy scheme for the retransmission of data if the number of bits, exclusive of the number of bits to be encoded (N_{SYS}), to be sent over the interface (N_{DATA} - N_{SYS}) is greater than said number (N_{PUNCT2}) of bits to be punctured in order to match the number of bits to be sent over the interface (N_{DATA}).

16. A method, according to claim 15, in which said selected predetermined incremental redundancy scheme is Partial Incremental Redundancy.

17. A retransmission mode selector adapted to implement a method according to any of the claims 1 to 16.

18. An incremental redundancy retransmission scheme selector, adapted to implement a method according to any of the claims 11 to 16.

19. A computer readable medium having processor executable instructions thereon for implementation by a processor, the instructions executing a method according to any of the claims 1 to 16.

20. A signal processing apparatus, in a transmitter unit adapted to transmit data to a receiver unit in acknowledged mode over an interface, comprising, for the transmission of data which have been first transmitted between said transmitter unit and a receiver unit over an interface, and for which no positive acknowledgement of said first transmission has been received at the transmitter unit, the data being processed according to an error correcting encoding scheme prior to transmission over the interface:
- first comparator means, for first comparing the number of bits to be encoded (N_{SYS}) and the number of bits to be sent over the interface;
- first control means, for determining, responsive to said first comparison, a type of retransmission mode for the retransmission of the first transmitted data.

21. A signal processing apparatus according to claim 20, further comprising:
- second comparator means, for second comparing a number of bits representative of an available memory size at the receiver unit (N_{IR}) and the number of bits to be sent over the air interface (N_{DATA});
- second control means, for determining, responsive to said first and second comparisons, a type of retransmission mode for the retransmission of the first transmitted data.

22. A signal processing apparatus according to claim 20 or 21, in which said first comparator means are adapted to compare the overall coding rate (N_{SYS}/N_{DATA}) with the error correcting encoding rate.

23. A signal processing apparatus, in a transmitter unit adapted to transmit data to a receiver unit in acknowledged mode over an interface, comprising, for the transmission of data which have been first transmitted between said transmitter unit and a receiver unit over an interface, and for which no positive acknowledgement of said first transmission has been received at the transmitter unit, the data being processed according to an error correcting encoding scheme and a rate matching scheme prior to transmission over the interface:
- means for determining whether the retransmission of data may be done according to an incremental redundancy retransmission scheme;
- means for calculating a number (N_{PUNCT2}) of bits to be punctured in order to match the number of bits to be sent over the interface (N_{DATA});
- means for comparing the number of bits, exclusive of the number of bits to be encoded, to be sent over the interface (N_{DATA} - N_{SYS}) and said number (N_{PUNCT2}) of bits to be punctured in order to match the number of bits to be sent over the interface (N_{DATA});
- means for selecting, responsive to said comparison, an incremental redundancy scheme for the retransmission of the first transmitted data.

24. A base station comprising a signal processing apparatus according to claims 20 to 23.

25. A mobile terminal comprising a signal processing apparatus according to claims 20 to 23.
